(19) Europäisches Patentamt / European Patent Office / Office européen des brevets

(11) EP 3 312 259 A1

(12) # EUROPEAN PATENT APPLICATION

(43) Date of publication:
**25.04.2018 Bulletin 2018/17**

(21) Application number: **17173402.3**

(22) Date of filing: **30.05.2017**

(51) Int Cl.:
***C09K 19/32*** *(2006.01)*
***C09K 19/38*** *(2006.01)*
***C09K 19/04*** *(2006.01)*
***C08F 220/00*** *(2006.01)*
***H01L 41/09*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **20.10.2016 JP 2016205694**

(71) Applicant: **Panasonic Intellectual Property Management Co., Ltd.**
**Osaka-shi, Osaka 540-6207 (JP)**

(72) Inventors:
- **HAYASHI, Naoki**
  **Osaka-shi, Osaka 540-6207 (JP)**
- **TAGASHIRA, Kenji**
  **Osaka-shi, Osaka 540-6207 (JP)**
- **ARASE, Hidekazu**
  **Osaka-shi, Osaka 540-6207 (JP)**

(74) Representative: **Grünecker Patent- und Rechtsanwälte**
**PartG mbB**
**Leopoldstraße 4**
**80802 München (DE)**

(54) ## ACTUATOR, LIQUID-CRYSTALLINE ELASTOMER, AND METHOD FOR FABRICATING THE SAME

(57) The present invention provides a liquid-crystalline elastomer having large generation force and a large amount of displacement. The liquid-crystalline elastomer according to the present invention is composed of a polymer of liquid-crystalline molecular units and cross-linking reagent units. Each of the cross-linking reagent units contains a bicyclo structure selected from the group consisting of a bicyclo [2,2,1] heptane structure or a bicyclo [2,2,2] octane structure. A molar ratio of the cross-linking reagents to the iquid-crystalline molecular units is not less than 0.1 and not more than 0.2. The bicyclo [2,2,1] heptane structure may be a trycyclodecane structure. The bicyclo [2,2,2] octane structure may be a trycycloundecane structure.

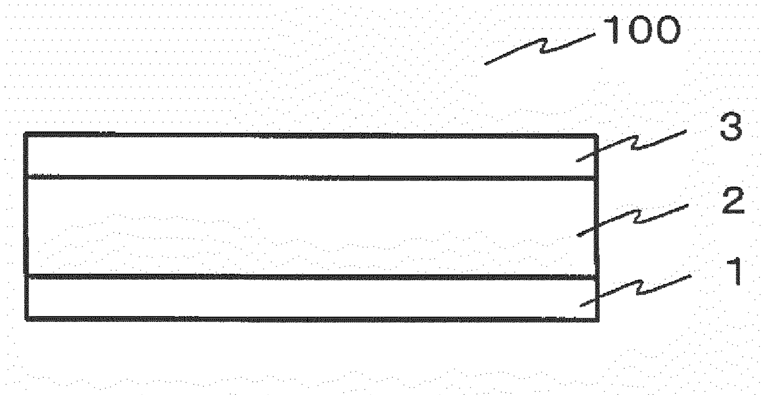


FIG. 1

EP 3 312 259 A1

**Description**

BACKGROUND

1. Technical Field

The present disclosure relates to an actuator, a liquid-crystalline elastomer and a method for fabricating the liquid-crystalline elastomer.

2. Description of the Related Art

Recently, development of a lightweight and highly-flexible soft actuator has been expected in light of safety and affinity for human with development of robots for industry, welfare, and caregiving, artificial muscles, medical devices, and regeneration medicine. A polymer actuator which is formed of conductive polymer, dielectric elastomer, or liquid-crystalline elastomer and which is capable of being transformed due to application or removal of an external stimulus (e.g., heat or electric field) is proposed. Among others, a liquid-crystalline elastomer containing liquid molecules in which the molecular orientation thereof is transformed due to the application or removal of the external stimulus in a polymer network has a characteristic of high durability, since the liquid-crystalline elastomer has high response speed and small volume change upon its contraction. Patent Literature 1 and Non-Patent Literatures 1 - 3 disclose liquid-crystalline elastomers each of which realizes displacement of not less than 20% upon its shape change due to heat. Non-Patent Literature 4 discloses making a gel-like liquid-crystalline elastomer swelled by absorption of a low molecular weight liquid crystal into a liquid-crystalline elastomer for the decrease in driving voltage. As just described, examples of various evaluation items for actuator performance are generation force, displacement, response speed, and energy efficiency. Various reports in which these performances are improved are provided.

CITATION LIST

Patent Literature

Patent Literature 1
Japanese unexamined patent publication No. 2009-191117A

Non-Patent Literature

Non Patent Literature 1
Donald L. Thomsen III et al., "Liquid Crystal Elastomers with Mechanical Properties of a Muscle", Macromolecules, 2001, Vol. 34, 5868-5875
Non Patent Literature 2
Reza Montazam et al. "Enhanced thermomechanical properties of a nematic liquid crystal elastomer doped with gold nanoparticles", Sensors and Actuators A, Vol. 178 (2012) pp. 175-178
Non Patent Literature 3
Etsushi Nishikawa et al. "Smectic-A liquid single crystal elastomers - strain inducedbreak-down of smectic layers", Macromolecular. Chemistry and Physics. Vol. 200, pp. 312-322 (1999)
Non Patent Literature 4
Yusril Yusuf et al. "Electromechanical and Electrooptical Effects of Liquid Crystal Elastomers Swollen with a Low Molecular Weight Liquid Crystal" Volume 477, 2007, Issue 1, pages 127-135

SUMMARY

The present invention provides an elastomer provided by polymerization of a liquid-crystalline monomer and a cross-linking reagent;
wherein
the cross-linking reagent is a compound represented by the following chemical formula (I):

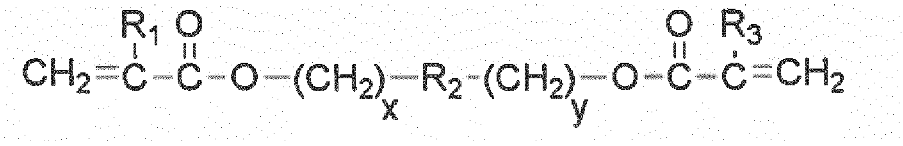

(I)

where

R1 and R3 are, each independently, a hydrogen atom or a methyl group,
x and y are, each independently, an integer of not less than 1 and not more than 10, and
R2 is represented by the following chemical formula (II).

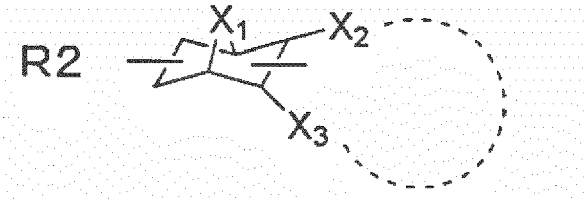

(II)

where

X1 represents an alkylene group having a carbon number of not less than 1 and not more than 2,
X2 and X3 are a hydrogen atom or an alkylene group each independently, or X2 and X3 is a cycloalkane having a ring structure in which X2 and X3 are bound to each other, and

the following mathematical formula (1) is satisfied.

$$0.1 \leq B/A \leq 0.2 \qquad (1)$$

where
A and B are a molar number of the liquid-crystalline monomer and a molar number of the cross-linking reagent, respectively.

The liquid-crystaNine elastomer provides large generation force and a large amount of displacement. The present invention includes an actuator comprising the liquid-crystalline elastomer. The present invention also includes a method for fabricating the liquid-crystalline elastomer.

BRIEF DESCRIPTION OF THE DRAWING

FIG. 1 is a schematic view of an actuator according to the embodiment of the disclosure.

DETAILED DESCRIPTION OF THE EMBODIMENT

The present inventors found a major practical problem that the actuators disclosed in Non-Patent Literatures 1 - 3 have low generation force. For example, the actuator for assisting motion of human is required to have generation force (0.2 MPa) to assist a biological muscle (0.3MPa). The actuators using liquid-crystalline elastomers disclosed in Non-Patent Literatures 1 - 3 fail to have generation force more than 0.2 MPa. In addition, in light of practical use of actuators, actuators are required not only to have large generation force but also to have a large amount of displacement. An object of the present disclosure is to provide a liquid-crystalline elastomer having a large generation power and a large amount of displacement.

The present disclosure includes an actuator, a liquid-crystalline elastomer, and a method for fabricating the liquid-crystalline elastomer.

An actuator according to one embodiment of the present disclosure comprises a pair of electrodes and a liquid-crystalline elastomer which is located between the pair of the electrodes. The liquid-crystalline elastomer is provided by polymerization of a liquid-crystalline monomer and a cross-linking reagent. The cross-linking reagent is a compound represented by the following chemical formula (I).

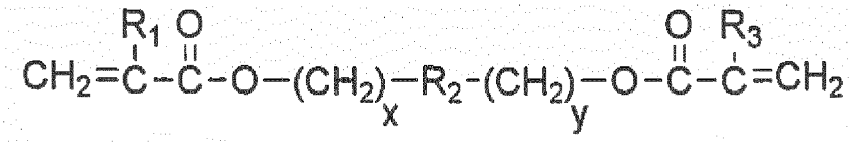
(I)

where

R1 and R3 are, each independently, a hydrogen atom or a methyl group,
x and y are, each independently, an integer of not less than 1 and not more than 10, and
R2 is represented by the following chemical formula (II).

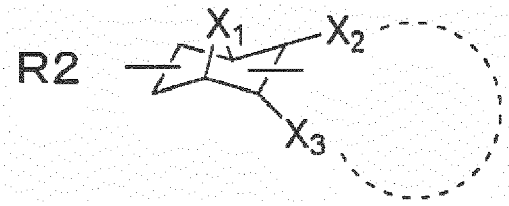
(II)

where

X1 represents an alkylene group having a carbon number of not less than 1 and not more than 2,
X2 and X3 are a hydrogen atom or an alkylene group each independently, or X2 and X3 is a cycloalkane having a ring structure in which X2 and X3 are bound to each other, and

the following mathematical formula (1) is satisfied.

$$0.1 \leq B/A \leq 0.2 \quad (1)$$

where
A and B are a molar number of the liquid-crystalline monomer and a molar number of the cross-linking reagent, respectively.

In one embodiment, the liquid-crystalline monomer is a compound represented by the following chemical formula (III).

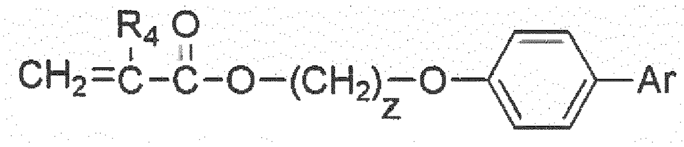
(III)

where

R4 is a hydrogen atom or a methyl group,
Z represents an integer of not less than 1 and not more than 10, and
Ar represents an aryl group having a substituent group.

The liquid-crystalline elastomer according to one embodiment of the disclosure is provided by polymerization of the liquid-crystalline monomer and the cross-linking reagent. The cross-linking reagent is a compound represented by the chemical formula (I).

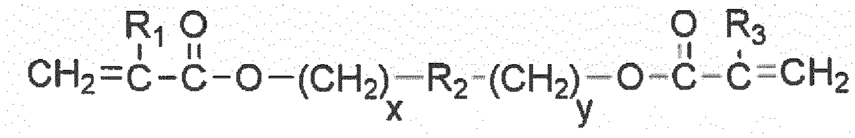 (I)

where

R1 and R3 are, each independently, a hydrogen atom or a methyl group,
x and y are, each independently, an integer of not less than 1 and not more than 10, and
R2 is represented by the following chemical formula (II).

R2 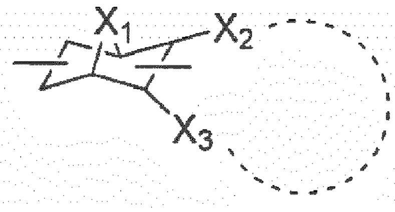 (II)

where

X1 represents an alkylene group having a carbon number of not less than 1 and not more than 2,
X2 and X3 are a hydrogen atom or an alkylene group each independently, or X2 and X3 is a cycloalkane having a ring structure in which X2 and X3 are bound to each other, and

the following mathematical formula (1) is satisfied.

$$0.1 \leq B/A \leq 0.2 \quad (1)$$

where
A and B are a molar number of the liquid-crystalline monomer and a molar number of the cross-linking reagent, respectively.

In one embodiment, the liquid-crystalline monomer is a compound represented by the following chemical formula (III).

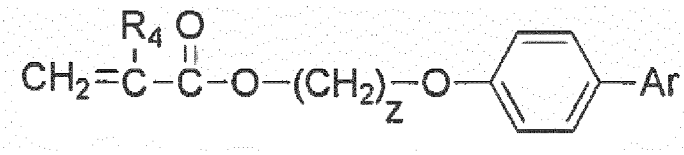 (III)

where

R4 is a hydrogen atom or a methyl group,
Z represents an integer of not less than 1 and not more than 10, and
Ar represents an aryl group having a substituent group.

A method according to one embodiment of the present disclosure is a method for fabricating a liquid-crystalline elastomer. The method comprises a step of polymerizing a liquid-crystalline monomer with a cross-linking reagent. The cross-linking reagent is a compound represented by the following chemical formula (I).

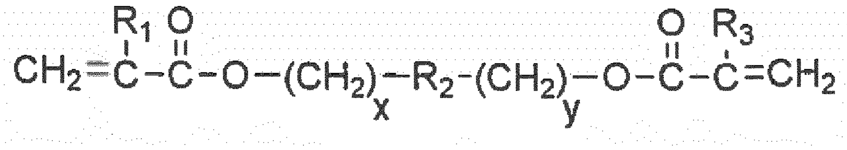 (I)

where

R1 and R3 are, each independently, a hydrogen atom or a methyl group,
x and y are, each independently, an integer of not less than 1 and not more than 10, and
R2 is represented by the following chemical formula (II).

R2 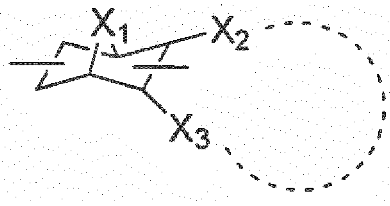 (II)

where

X1 represents an alkylene group having a carbon number of not less than 1 and not more than 2,
X2 and X3 are a hydrogen atom or an alkylene group each independently, or X2 and X3 is a cycloalkane having a ring structure in which X2 and X3 are bound to each other, and

the following mathematical formula (1) is satisfed.

$$0.1 \leq B / A \leq 0.2 \quad (1)$$

where
A and B are a molar number of the liquid-crystalline monomer and a molar number of the cross-linking reagent, respectively.

In one embodiment, the liquid-crystalline monomer is a compound represented by the following chemical formula (III).

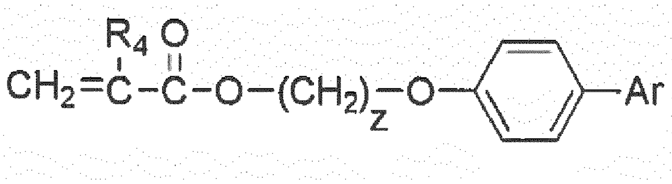 (III)

where

R4 is a hydrogen atom or a methyl group,
Z represents an integer of not less than 1 and not more than 10, and
Ar represents an aryl group having a substituent group.

The actuator according to the present disclosure comprises a liquid-crystalline elastomer according to the above-mentioned present disclosure. When a voltage is applied to the pair of the electrodes, the liquid-crystalline molecule is oriented so as to be parallel to a direction of the electric field (i.e., the direction from one electrode to the other electrode). With the molecule orientation of the liquid-crystalline molecule, the polymer chain which is bound covalently to the liquid-crystalline molecule follows the orientation change of the liquid-crystal molecule to be transformed so as to be parallel to the direction of the electric field. As a result, the liquid-crystalline elastomer according to the present disclosure is extended and transformed along the direction of the electric field, whereas the liquid-crystalline elastomer according to

the present disclosure is contracted and transformed in a direction parallel to a plane of the electrode. Since the liquid-crystalline elastomer according to the present disclosure is transformed using the change of the molecular orientation of the liquid-crystalline molecule as a driving source and has a highly-elastic cross-linking structure, the liquid-crystalline elastomer according to the present disclosure provides large generation force and a large amount of displacement. For this reason, the actuator according to the present disclosure comprising the liquid-crystalline elastomer according to the above-mentioned liquid-crystalline elastomer as a membrane responsive to an electric field provides large generation force and a large amount of displacement, even when transformed due to the application of the electric field.

Hereinafter, the embodiment of the present disclosure will be described.

The liquid-crystalline elastomer according to the present disclosure is an elastomer provided by polymerization of a liquid-crystalline monomer (A) and a cross-linking reagent (B). The liquid-crystalline monomer (A) is represented by the following chemical formula (III).

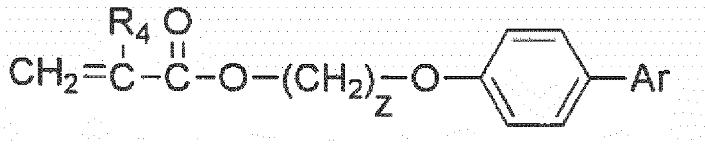

(III)

where

R4 is a hydrogen atom or a methyl group,
Z represents an integer of not less than 1 and not more than 10, and
Ar represents an aryl group having a substituent group.

In the chemical formula (III), it is desirable that Ar is an aryl group having a substituent group having large electronegativity to add dipole moment to the liquid-crystalline monomer.

For example, the liquid-crystalline monomer (A) is a compound represented by the following structural formula (A1) - (A5). However, the liquid-crystalline monomer (A) is not limited thereto.

(A1)

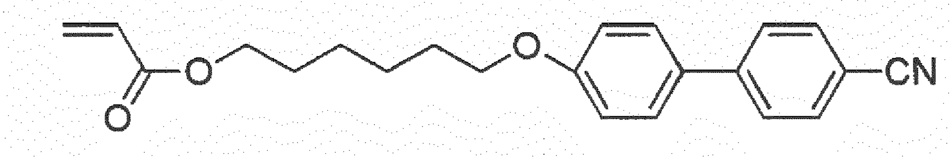

(A2)

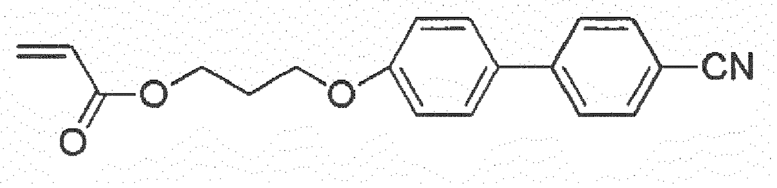

(A3)

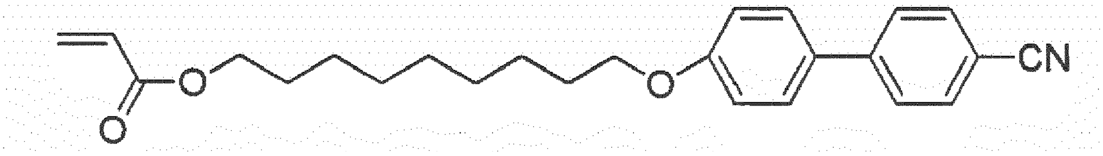

(A4)

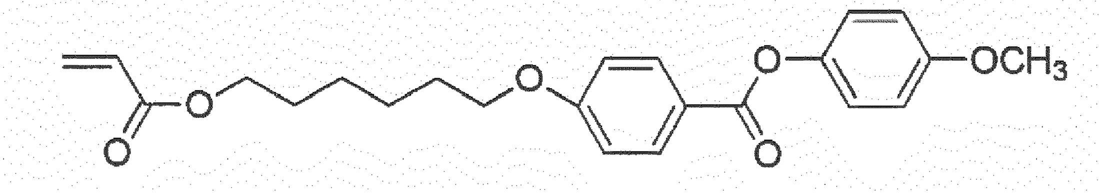

(A5)

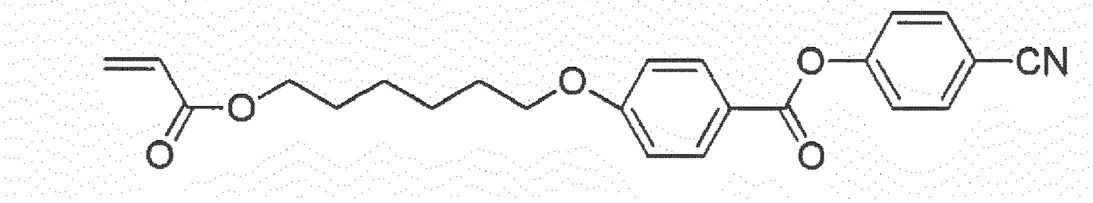

Among others, the liquid-crystalline monomer represented by the structural formula (A1) is desirable, since structural formula (A1) has a cyano group having high electronegativity and is a liquid-crystalline molecule having a large dielectric anisotropy as a side chain.

The cross-linking reagent (B) is a monomer having two or more polymerizable functional groups. The cross-linking reagent (B) is represented by the following chemical formula (I).

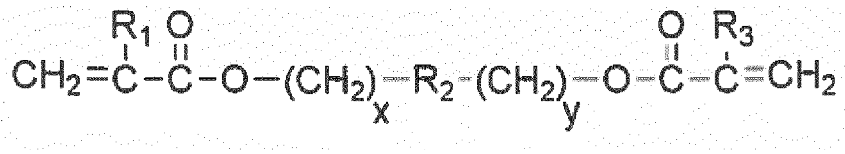 (I)

where

R1 and R3 are, each independently, a hydrogen atom or a methyl group,
x and y are, each independently, an integer of not less than 1 and not more than 10, and
R2 is represented by the following chemical formula (II).

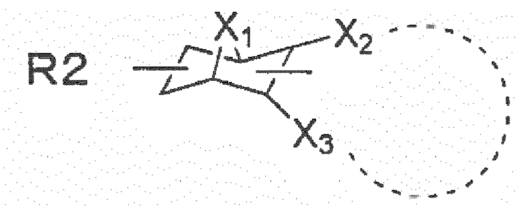 (II)

where

X1 represents an alkylene group having a carbon number of not less than 1 and not more than 2, and
X2 and X3 are a hydrogen atom or an alkylene group each independently, or X2 and X3 is a cycloalkane having

a ring structure in which X2 and X3 are bound to each other.

Among others, it is desirable that the cross-linking reagent (B) is a cross-linking reagent represented by the structural formula (B1) in which X1 is a methylene group having a carbon number of one and X2 and X3 is a cyclopentane which forms a ring structure. Since the cross-linking reagent represented by the structural formula (B1) has a ring structure, the cross-linking reagent represented by the structural formula (B1) has rigidity. In addition, since the cross-linking reagent represented by the structural formula (B1) has a structure bounded singly, the cross-linking reagent represented by the structural formula (B1) has a structural formula having more flexibility than one having an aromatic ring.

(B1)

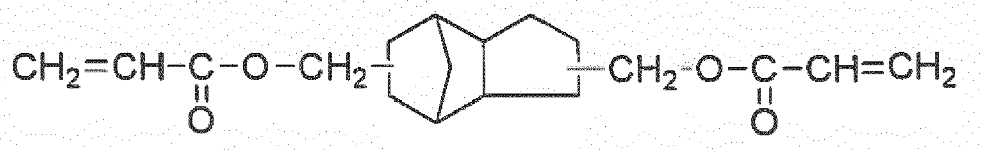

(Mechanism of improvement in the generation force by the present cross-linking reagent)

Rubber elasticity is added to the liquid-crystalline elastomer by cross linking of polymer chains with the cross-linking reagent. When the molecular orientation of the liquid-crystalline changes due to the external stimulus (e.g., heat or electric field), the change is propagated to the polymer chain. As a result, the polymer chain is transformed. The transformation of the polymer chain is propagated to the whole of the liquid-crystalline elastomer via a cross-linking site in which the polymer chains are bound to each other. As a result, the whole of the liquid-crystalline elastomer is transformed elastically. In the liquid-crystalline elastomer fabricated using the cross-linking reagent according to the present disclosure, the cross-linking site has a rigid structure. The transformation of the polymer chain is propagated to the whole of the liquid-crystalline elastomer in a condition where relief of force is small. As a result, the large generation force and the large amount of displacement are provided.

In addition, the liquid-crystalline elastomer according to the present disclosure is characterized by that the composition ratio of the cross-linking reagent to the liquid-crystalline monomer satisfies the following formula (1).

$$0.1 \leq B/A \leq 0.2 \qquad (1)$$

where
A and B are a molar number of the liquid-crystalline monomer and a molar number of the cross-linking reagent, respectively.

(Description of the optimum composition ratio of the present cross-linking reagent to the liquid-crystalline monomer)

In case where the composition ratio of the cross-linking reagent to the liquid-crystalline monomer is less than 0.1, since the density of the cross-linking reagent is small, the transformation of the polymer chain fails to be propagated to the whole of the liquid-crystalline elastomer in the condition where relief of force is small. On the other hand, in case where the composition ratio of the cross-linking reagent to the liquid-crystalline monomer is more than 0.2, since the density of the cross-linking reagent is high, the orientation of the liquid-crystalline molecule is disturbed. As a result, the liquid-crystalline elastomer has a polydomain structure in which macroscopical orientation is absent. Even when the external stimulus used to disturb the orientation is applied to the liquid-crystalline elastomer having a polydomain structure, the liquid-crystalline elastomer fails to be transformed, since the liquid-crystalline molecule is oriented isotropically by its nature. In addition, when the density of the cross-linking reagent is high, the liquid-crystalline elastomer fails to be transformed, since the polymer chain does not move easily. As just described, as long as the composition ratio of the cross-linking reagent to the liquid-crystalline monomer falls within the range defined by the above formula (1), the fabricated elastomer according to the present disclosure provides large generation force and the large amount of displacement.

(A method for fabricating the liquid-crystalline elastomer)

Hereinafter, a method for fabricating the liquid-crystalline elastomer according to the present disclosure will be described. However, a method for fabricating the liquid-crystalline elastomer according to the present disclosure is not limited to this method.

A liquid-crystalline monomer, a low molecule liquid-crystalline of 4-(hexyloxy)-4'-cyano biphenyl (1 equivalent), and a polymerization initiator (0.005 equivalent, trade name: Irgacure651) are dissolved in chloroform. Then, a cross-linking reagent (0.14 equivalents) is mixed, dissolved, and heated at 50 degrees Celsius. In this way, chloroform is removed evaporatively. The mixture of the liquid-crystalline monomer and the cross-linking reagent is referred to as a "liquid-crystalline base material".

A glass substrate having a horizontal oriented film is fabricated via the following steps. After a polyimide solution is applied to the glass substrate, a film is formed by sintering treatment. After the film formation, rubbing treatment is conducted to allow the orientation direction of the liquid-crystalline molecules to be uniform. In this way, the glass substrate having a horizontal oriented film is provided.

A spacer having a thickness of 50 micrometers is interposed between the two glass substrates each having the horizontal oriented film in such a manner that two rubbing directions are antiparallel. In this way, a sandwich cell is fabricated. A liquid-crystalline base material is injected in the sandwich cell using capillary tube phenomenon. During the injection, to avoid a flow orientation, the liquid-crystalline base material is heated to 80 degrees Celsius at a temperature of which the liquid crystal has an isotropic phase. After the liquid-crystalline base material are permeated throughout the cell, the liquid-crystalline base material is cooled to a temperature (i.e., 25 degrees Celsius) at which a liquid-crystalline phase is exhibited. It is desirable to confirm that the liquid-crystalline molecules are oriented uniformly along the rubbing direction using a light polarizer. Specifically, an extinction position is provided throughout the cell when the rubbing direction accords to the direction of the light polarizer. Then, the cell is rotated to provide a bright light position throughout the cell. In this way, it is confirmed that the liquid-crystalline molecules are oriented uniformly along the rubbing direction throughout the cell.

In a condition where the liquid-crystalline phase is exhibited, the base material contained in the cell is irradiated with an ultra-violet light (wavelength: 365 nm, intensity: 30 mW / $cm^2$, period: 30 minutes) using an ultra-violet light emitting diode. In this way, the base material is cured. After the irradiation, it is desirable to confirm that the liquid-crystalline molecules are oriented uniformly along the rubbing direction using a light polarizer.

The film cured due to the ultra-violet light is immersed in dichloromethane to swell. Then, the film is removed from the cell. The removed film is washed using dichloromethane. In this way, unreacted components are removed. Methanol is added to substitute a solvent. In this way, dichloromethane contained in the film is removed. Finally, the film is dried at a room temperature. In this way, the liquid-crystalline elastomer film is provided.

(Electrode)

The material of the electrode is not limited to the followings. For example, the material of the electrode may be an electrically-conductive paste in which an electrically-conductive material of metal particles such as silver particles or carbon particles such as carbon nano tubes or carbon black particles is dispersed in a binder such as a silicone oil or an elastomer. Electrode having a surface on which an electrically-conductive material such as a metal or a carbon material is patterned so as to have a shape of a comb or a mesh may be used. Such an electrode is capable of extending or contacting together with the liquid-crystalline elastomer. Therefore, the electrode does not prevent the actuator from being transformation.

(Actuator)

FIG. 1 shows a schematic view of an actuator 100 according to the embodiment of the present disclosure.

The actuator 100 comprises a first electrode 1, a liquid-crystalline elastomer film 2, and a second electrode 3. The first electrode 1 and the second electrode 3 are adhered to the back surface and the front surface of the liquid-crystalline elastomer film 2, respectively. The first electrode 1 and the second electrode 3 are electrically connected to a power source through a conducting wire. When a voltage is applied between the first electrode 1 and the second electrode 3, the liquid-crystalline elastomer film 2 is contracted with regard to the electrode surface in a case where the dielectric anisotropy of the contained liquid-crystalline molecule is positive, whereas the liquid-crystalline elastomer film 2 is extended with regard to the electrode surface in a case where the dielectric anisotropy is negative.

EXAMPLES

Hereinafter, the present disclosure will be described with reference to the inventive examples and the comparative examples in more detail. The present inventors fabricated the liquid-crystalline elastomer according to the inventive examples 1 - 3 and the comparative examples 1 - 8 to evaluate the characteristics thereof. Table 1 shows the summary of the evaluation results.

(Inventive example 1)

(Fabrication of the liquid-crystalline elastomer)

The liquid-crystalline monomer (A1) was synthesized by the following process.

First, the present inventors added ethanol (35 ml, purchased from Wako Pure Chemical Industries, Ltd. CAS: 64-17-5) and a sodium hydroxide aqueous solution (0.4 grams, 5 mmol, pure water: 0.6 mL, purchased from Wako Pure Chemical Industries, Ltd. CAS: 1310-73-2) to 4-cyano-4'-hydroxybiphenyl (0.976 grams, 5 mmol, purchased from Tokyo Chemical Industry Co., Ltd, CAS:19812-93-2) to prepare a mixture. 4-cyano-4'-hydroxybiphenyl was dissolved in the mixture at a temperature of 80 degrees Celsius, and then, the present inventors added 6-bromo-1-hexanol (1.086 grams, 6 mmol, purchased from Wako Pure Chemical Industries, Ltd. CAS: 4286-55-9) to the mixture to react for 24 hours with a reflux apparatus. After the reaction, the solvent was removed. The product material was washed using hydrochloric acid (1.2 M, 8 milliliters, purchased from Wako Pure Chemical Industries, Ltd. CAS: 7647-01-0). A white precipitate was filtered. The present inventors added dichloromethane (purchased from Wako Pure Chemical Industries, Ltd. CAS: 75-09-2) to the residue to dissolve it. Then, the present inventors extracted the filtrate and purified through solvent removal, fractionation with column chromatography, and recrystallization with hexane (purchased from Wako Pure Chemical Industries, Ltd. CAS: 110-54-3). In this way, the present inventors obtained 4'-(6-hydroxy-hexyloxy)-biphenyl-4-carbonitrile as a white crystal.

Then, the present inventors added dichloromethane (7 milliliters) and triethylamine (0.33 milliliters, 2.38 mmol, purchased from Wako Pure Chemical Industries, Ltd. CAS: 121-44-8) to 4'-(6-hydroxy-hexyloxy)-biphenyl-4-carbonitrile (0.404 milligrams, 1.59 mmol) to prepare a mixture, and then, cooled the mixture to 0 degrees Celsius. The present inventors dripped acrylic acid chloride (128 microliters, 1.59 mmol, purchased from Tokyo Chemical Industry Co., Ltd, CAS: 814-68-6) slowly into the mixture, and then, stirred at a room temperature for 24 hours. The present inventors stirred at a temperature of 70 degrees Celsius overnight to react, until a crystal was precipitated completely. After the reaction, the solvent was removed, and then, the reaction product was extracted by a separation process using a mixture of dichloromethane and water. After the solvent was removed, the reaction product was fractionated with column chromatography, and then, purified through the recrystallization using hexane. In this way, the liquid-crystalline monomer (A1) was obtained as a white crystal.

The present inventors fabricated a liquid-crystalline elastomer by polymerizing the monomer represented by the following structural formula (A1) as a liquid-crystalline monomer with a cross-linking reagent represented by the following structural formula (B1) as a cross-linking reagent.

(A1)

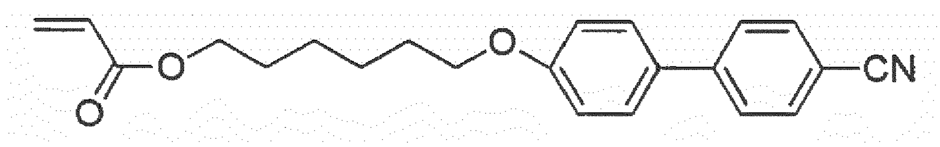

(B1)

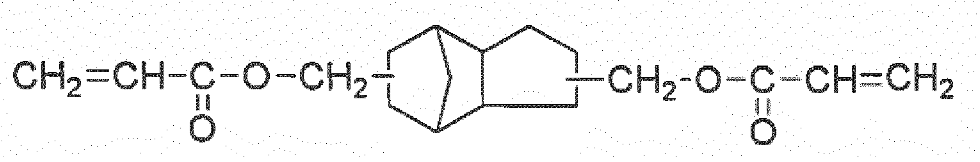

Hereinafter, the fabrication method of the liquid-crystalline elastomer according to the present disclosure will be described.

The present inventors dissolved the liquid-crystalline monomer (A1) (50 milligrams, 0.143 mmol) and a low molecule liquid crystal of 4'-cyano-4-hexyl oxybiphenyl (39.9 milligrams, 0.143 mmol, purchased from Tokyo Chemical Industry Co., Ltd, CAS: 41424-11-7), and a polymerization initiator (0.37 milligrams, 1.43 micromol, purchased from Tokyo Chemical Industry Co., Ltd, CAS: 24650-42-8, trade name: IrgacureB51) in chloroform (0.2 milliliters) to prepare a mixture, and then, mixed the cross-linking reagent (B1) (0.14 equivalents, 6.1 milligrams, 0.020 mmol, purchased from Kyoeisha Chemical Co., Ltd. CAS: 42594-17-2) with the mixture to dissolve it in the mixture. Then, the present inventors heated the mixture at 50 degrees Celsius to remove the chloroform evaporatively. Hereinafter, the mixture of the liquid-crystalline monomer and the cross-linking reagent is referred to as a liquid-crystalline base material.

A glass substrate having a horizontal oriented film was fabricated via the following steps. After a polyimide solution was applied to the glass substrate, a film was formed by sintering treatment. After the film formation, rubbing treatment was conducted to allow the orientation direction of the liquid-crystalline molecules to be uniform. In this way, the glass substrate having a horizontal oriented film was provided.

A spacer having a thickness of 50 micrometers was interposed between the two glass substrates each having the horizontal oriented film in such a manner that two rubbing directions were antiparallel. In this way, a sandwich cell was fabricated. A liquid-crystalline base material was injected in the sandwich cell using capillary tube phenomenon. During the injection, to avoid a flow orientation, the liquid-crystalline base material was heated to 80 degrees Celsius at a temperature of which the liquid crystal had an isotropic phase. After the liquid-crystalline base material were permeated throughout the cell, the liquid-crystalline base material was cooled to a temperature (i.e., 25 degrees Celsius) at which a liquid-crystalline phase was exhibited. The present inventors confirmed that the liquid-crystalline molecules were oriented uniformly along the rubbing direction using a light polarizer. Specifically, an extinction position was provided throughout the cell when the rubbing direction accorded to the direction of the light polarizer. Then, the cell was rotated to provide a bright light position throughout the cell. In this way, the present inventors confirmed that the liquid-crystalline molecules are oriented uniformly along the rubbing direction throughout the cell.

In a condition where the liquid-crystalline phase was exhibited, the base material contained in the cell was irradiated with an ultra-violet light (wavelength: 365 nm, intensity: 30 mW / $cm^2$, period: 30 minutes) using an ultra-violet light emitting diode. In this way, the base material was cured. After the irradiation, the present inventors confirmed that the liquid-crystalline molecules were oriented uniformly along the rubbing direction using a light polarizer.

The film cured due to the ultra-violet light was immersed in dichloromethane to swell. Then, the film was removed from the cell. The removed cell was washed using dichloromethane. In this way, unreacted components were removed. Methanol was added to substitute a solvent. In this way, dichloromethane contained in the film was removed. Finally, the film was dried at a room temperature. In this way, the liquid-crystalline elastomer film according to the inventive example 1 was provided.

(Evaluation of Actuator Performance of Liquid-crystalline Elastomer)

The present inventors heated the thus-provided liquid-crystalline elastomer according to the inventive example 1 as an external stimulus to measure generation force and an amount of displacement thereof. For the measurement and the evaluation, a thermomechanical analysis device (hereinafter, "TMA device") was used. Specifically, the present inventors cut the liquid-crystalline elastomer film so as to have a shape of a rectangular of 15 millimeters vertical by 5 millimeters horizontal size. The cut film had an orientation direction parallel to the longitudinal direction. Both longitudinal ends of the cut film were bound with chucks. In other words, the orientation direction was parallel to the direction from the one chuck to the other chuck. The distance between the chucks was adjusted to be 10 millimeters. The present inventors loaded the sample into a heater. The sample was heated, while the sample was drawn with a weight. The heat causes phase transition of the liquid-crystalline molecules from the liquid-crystalline phase to the isotropic phase. For this reason, the condition of the liquid-crystalline molecules was changed from a condition where the liquid-crystalline molecules were oriented uniformly to a condition where the liquid-crystalline molecules were disposed randomly. As a result, the liquid-crystalline elastomer was contracted along the orientation direction. Hereinafter, a rate of this contraction is referred to as displacement. The displacement is calculated on the basis of the following formula (2).

$$\text{Displacement} = (1 - L / L_0) \times 100 \qquad (2)$$

$L_0$: distance between the chucks of the liquid-crystalline elastomer film before the contraction.
L: distance between the chucks of the liquid-crystalline elastomer film after the contraction.

The present inventors measured the displacement of the liquid-crystalline elastomer film according to the inventive example 1 using the TMA device. As a result, the present inventors confirmed the performance that the

displacement was 11% in a case where the generation force was 0.28 MPa.

(Inventive example 2)

In the inventive example 2, an experiment similar to the inventive example 1 was conducted, except that the liquid-crystalline base material was prepared in such a manner that the addition amount of the cross-linking reagent (B1) was 0.1 equivalent (4.4 milligram, 0.014mmol). In this way, a liquid-crystalline elastomer film according to the inventive example 2 was provided.

The actuator performance of the liquid-crystalline elastomer film according to the inventive example 2 was evaluated similarly to the case of the inventive example 1. The result is shown in Table 1.

(Inventive example 3)

In the inventive example 3, an experiment similar to the inventive example 1 was conducted, except that the liquid-crystalline base material was prepared in such a manner that the addition amount of the cross-linking reagent (B1) was 0.2 equivalent (8.8 milligram, 0.028 mmol). In this way, a liquid-crystalline elastomer film according to the inventive example 3 was provided.

The actuator performance of the liquid-crystalline elastomer film according to the inventive example 3 was evaluated similarly to the case of the inventive example 1. The result is shown in Table 1.

(Comparative example 1)

In the comparative example 1, an experiment similar to the inventive example 1 was conducted, except that a cross-linking reagent (0.14 equivalents, 4.5 milligrams, 0.020 mmol, purchased from Tokyo Chemical Industry Co., Ltd, CAS: 13048-33-4) having the following structural formula (B2) was used in place of the cross-linking reagent (B1). In this way, a liquid-crystalline elastomer film according to the comparative example 1 was provided.

(B2)

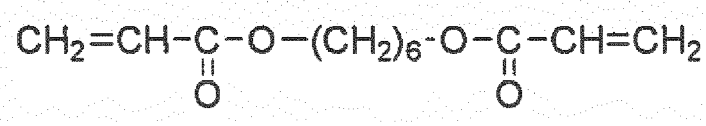

The actuator performance of the liquid-crystalline elastomer film according to the comparative example 1 was evaluated similarly to the case of the inventive example 1. The result is shown in Table 1.

(Comparative example 2)

In the comparative example 2, an experiment similar to the inventive example 1 was conducted, except that a cross-linking reagent (0.14 equivalents, 4.4 milligrams, 0.020 mmol, purchased from Funakoshi Co., Ltd: CAS: 6729-79-9) having the following structural formula (B3) was used in place of the cross-linking reagent (B1). In this way, a liquid-crystalline elastomer film according to the comparative example 2 was provided.

(B3)

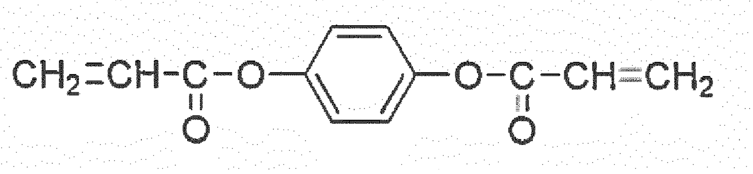

The actuator performance of the liquid-crystalline elastomer film according to the comparative example 2 was evaluated similarly to the case of the inventive example 1. The result is shown in Table 1.

(Comparative examples 3 - 8)

In the comparative examples 3 - 8, an experiment similar to the inventive example 1 was conducted, except that an additive amount of the cross-linking reagent (B1) was changed as below.
In the comparative example 3, 0.02 equivalents, 0.88 milligrams, 0.0028 mmol.
In the comparative example 4, 0.04 equivalents, 1.76 milligrams, 0.0056 mmol.
In the comparative example 5, 0.08 equivalents, 3.52 milligrams, 0.0112 mmol.
In the comparative example 6, 0.09 equivalents, 3.96 milligrams, 0.0126 mmol.
In the comparative example 7, 0.21 equivalents, 9.24 milligrams, 0.0294 mmol.
In the comparative example 8, 0.28 equivalents, 12.3 milligrams, 0.0392 mmol.
In this way, the liquid-crystalline elastomer films according to the comparative examples 3 - 8 were provided.
The actuator performance of the liquid-crystalline elastomer films according to the comparative examples 3 - 8 was evaluated similarly to the case of the inventive example 1. The results are shown in Table 1.

[Table 1]

| | Liquid-crystalline monomer | Cross-linking reagent | B/A | Generation Force (MPa) | Displacement (%) |
|---|---|---|---|---|---|
| Inventive Example 1 | A1 | B1 | 0.14 | 0.28 | 11 |
| Inventive Example 2 | A1 | B1 | 0.10 | 0.21 | 13 |
| Inventive Example 3 | A1 | B1 | 0.20 | 0.26 | 11 |
| Comparative Example 1 | A1 | B2 | 0.14 | 0.15 | 14 |
| Comparative Example 2 | A1 | B3 | 0.14 | 0.25 | 6 |
| Comparative Example 3 | A1 | B1 | 0.02 | 0.078 | >25 |
| Comparative Example 4 | A1 | B1 | 0.04 | 0.13 | >35 |
| Comparative Example 5 | A1 | B1 | 0.08 | 0.15 | 20 |
| Comparative Example 6 | A1 | B1 | 0.09 | 0.16 | 17 |
| Comparative Example 7 | A1 | B1 | 0.21 | - | 0 |
| Comparative Example 8 | A1 | B1 | 0.28 | - | 0 |

As shown in Table 1, the liquid-crystalline elastomer films according to the inventive examples 1 - 3 provide high generation force of not less than 0.2 MPa and large displacement of not less than 10%. On the other hand, the liquid-crystalline elastomer according to the comparative example 1 provides low generation force. The liquid-crystalline elastomer according to the comparative example 2 provides high generation force, however, low displacement. This is because the flexibility required as an actuator was lowered due to high rigidity of the cross-linking structure, the present inventors believe. The liquid-crystalline elastomer films according to the comparative examples 3-6 failed to provide high generation force. This means that the effect of the cross-linking structure of the present disclosure is insufficient. The liquid-crystalline elastomer films according to the comparative example 7-8 failed to be transformed. This is because the orientation of the liquid-crystalline molecules was disturbed due to high concentration of the cross-linking reagent in the liquid-crystalline elastomer films according to the comparative examples 7 - 8. As a result, each of the liquid-crystalline elastomer films according to the comparative examples 7 - 8 had a polydomain structure in which macroscopical orientation was absent.

## INDUSTRIAL APPLICABILITY

The actuator according to the present disclosure can be comprised in a robot for welfare and caregiving.

## REFERENTIAL SIGNS LIST

| | |
|---|---|
| 1 | First electrode |
| 2 | Liquid-crystalline elastomer film |
| 3 | Second electrode |
| 100 | Actuator |

## Claims

**1.** An actuator, comprising:

a pair of electrodes; and
a liquid-crystalline elastomer located between the pair of the electrodes,
wherein
the liquid-crystalline elastomer is provided by polymerization of a liquid-crystalline monomer and a cross-linking reagent;
the cross-linking reagent is a compound represented by the following chemical formula (I):

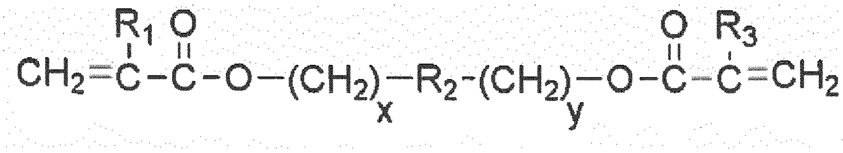 (I)

where

R1 and R3 are, each independently, a hydrogen atom or a methyl group,
x and y are, each independently, an integer of not less than 1 and not more than 10, and
R2 is represented by the following chemical formula (II).

R2 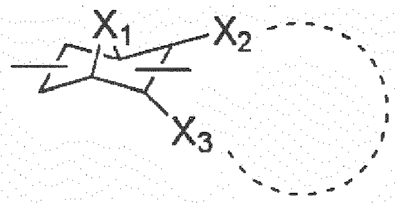 (II)

where

X1 represents an alkylene group having a carbon number of not less than 1 and not more than 2,
X2 and X3 are a hydrogen atom or an alkylene group each independently, or X2 and X3 is a cycloalkane having a ring structure in which X2 and X3 are bound to each other, and

the following mathematical formula (1) is satisfied.

$$0.1 \leq B / A \leq 0.2 \quad (1)$$

where

A and B are a molar number of the liquid-crystalline monomer and a molar number of the cross-linking reagent, respectively.

**2.** The actuator according to Claim 1, wherein

the liquid-crystalline monomer is a compound represented by the following chemical formula (III).

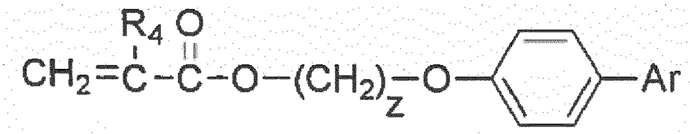

(III)

where

R4 is a hydrogen atom or a methyl group,
Z represents an integer of not less than 1 and not more than 10, and
Ar represents an aryl group having a substituent group.

**3.** An elastomer provided by polymerization of a liquid-crystalline monomer and a cross-linking reagent;

wherein
the cross-linking reagent is a compound represented by the following chemical formula (I):

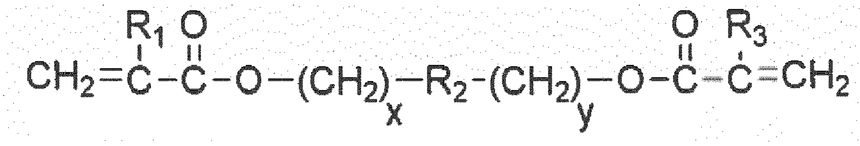

(I)

where

R1 and R3 are, each independently, a hydrogen atom or a methyl group,
x and y are, each independently, an integer of not less than 1 and not more than 10, and
R2 is represented by the following chemical formula (II).

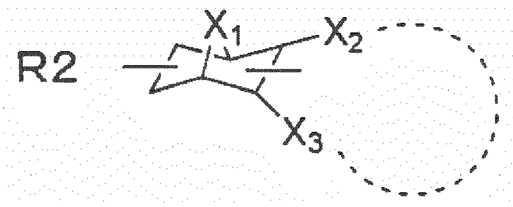

(II)

where

X1 represents an alkylene group having a carbon number of not less than 1 and not more than 2,
X2 and X3 are a hydrogen atom or an alkylene group each independently, or X2 and X3 is a cycloalkane having a ring structure in which X2 and X3 are bound to each other, and

the following mathematical formula (1) is satisfied.

$$0.1 \leq B / A \leq 0.2 \quad (1)$$

where
A and B are a molar number of the liquid-crystalline monomer and a molar number of the cross-linking reagent,

respectively.

**4.** The liquid-crystalline elastomer according to Claim 3, wherein

the liquid-crystalline monomer is a compound represented by the following chemical formula (III).

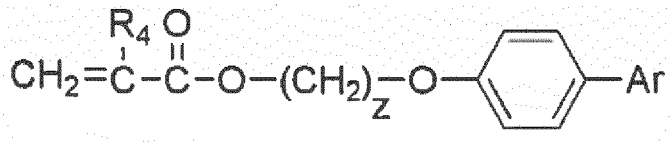

(III)

where

R4 is a hydrogen atom or a methyl group,
Z represents an integer of not less than 1 and not more than 10, and
Ar represents an aryl group having a substituent group.

**5.** A method for fabricating a liquid-crystalline elastomer, comprising:

(a) polymerizing a liquid-crystalline monomer with a cross-linking reagent, wherein
the cross-linking reagent is a compound represented by the following chemical formula (I):

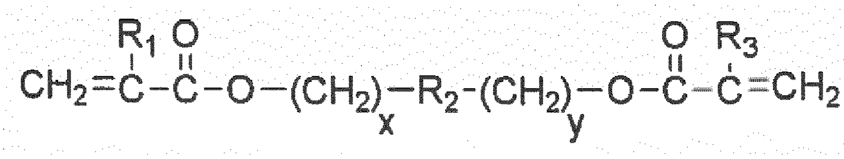

(I)

where

R1 and R3 are, each independently, a hydrogen atom or a methyl group,
x and y are, each independently, an integer of not less than 1 and not more than 10, and
R2 is represented by the following chemical formula (II).

R2 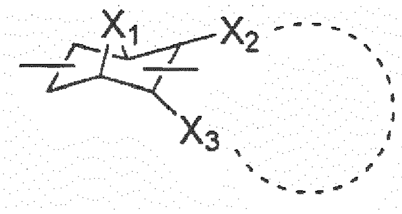

(II)

where

X1 represents an alkylene group having a carbon number of not less than 1 and not more than 2,
X2 and X3 are a hydrogen atom or an alkylene group each independently, or X2 and X3 is a cycloalkane having a ring structure in which X2 and X3 are bound to each other, and
the following mathematical formula (1) is satisfied.

$$0.1 \leq B / A \leq 0.2 \quad (1)$$

where
A and B are a molar number of the liquid-crystalline monomer and a molar number of the cross-linking reagent, respectively.

**6.** The method according to Claim 5, wherein

the liquid-crystalline monomer is a compound represented by the following chemical formula (III).

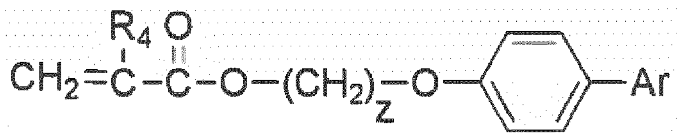 (III)

where

R4 is a hydrogen atom or a methyl group,
Z represents an integer of not less than 1 and not more than 10, and
Ar represents an aryl group having a substituent group.

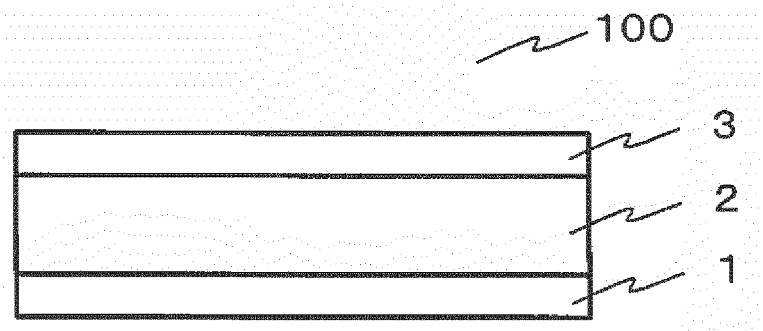


FIG. 1

Europäisches Patentamt
European Patent Office
Office européen des brevets

# EUROPEAN SEARCH REPORT

Application Number
EP 17 17 3402

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2016/068756 A1 (MORIYA CHIE [JP] ET AL) 10 March 2016 (2016-03-10)<br>* comparative example 12; page 23 *<br>----- | 5<br>1-4,6 | INV.<br>C09K19/32<br>C08F220/00<br>C09K19/38<br>H01L41/09<br>C09K19/04 |
| A,D | JP 2009 191117 A (TOKAI RUBBER IND LTD) 27 August 2009 (2009-08-27)<br>* claims 1, 5 *<br>----- | 1-6 | |
| A | THOMSEN DONALD L ET AL: "Liquid Crystal Elastomers with Mechanical Properties of a Muscle",<br>MACROMOLECULES, AMERICAN CHEMICAL SOCIETY, US,<br>vol. 34, 1 January 2001 (2001-01-01), pages 5868-5875, XP002191513,<br>ISSN: 0024-9297, DOI: 10.1021/MA001639Q<br>* abstract *<br>----- | 1-6 | |
| A | MOHAND O. SAED ET AL: "Synthesis of Programmable Main-chain Liquid-crystalline Elastomers Using a Two-stage Thiol-acrylate Reaction",<br>JOURNAL OF VISUALIZED EXPERIMENTS,<br>vol. 107379153546, no. 107,<br>1 January 2016 (2016-01-01), page 53546,<br>XP055422932,<br>DOI: 10.3791/53546<br>* page 2 *<br>----- | 1-6 | TECHNICAL FIELDS SEARCHED (IPC)<br>C09K<br>C08F<br>H01L |
| A | JP H07 26193 A (MATSUSHITA ELECTRIC IND CO LTD) 27 January 1995 (1995-01-27)<br>* example 7 *<br>----- | 1-6 | |

The present search report has been drawn up for all claims

2

| Place of search | Date of completion of the search | Examiner |
|---|---|---|
| The Hague | 13 November 2017 | Bomm, Jana |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO. EP 17 17 3402

This annex lists the patent family members relating to the patent documents cited in the above-mentioned European search report. The members are as contained in the European Patent Office EDP file on
The European Patent Office is in no way liable for these particulars which are merely given for the purpose of information.

13-11-2017

| Patent document cited in search report | Publication date | Patent family member(s) | Publication date |
|---|---|---|---|
| US 2016068756 A1 | 10-03-2016 | JP 6149078 B2 | 14-06-2017 |
| | | JP 2016051178 A | 11-04-2016 |
| | | KR 20160026780 A | 09-03-2016 |
| | | US 2016068756 A1 | 10-03-2016 |
| JP 2009191117 A | 27-08-2009 | NONE | |
| JP H0726193 A | 27-01-1995 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009191117 A


### Non-patent literature cited in the description


- **DONALD L. THOMSEN III et al.** Liquid Crystal Elastomers with Mechanical Properties of a Muscle. *Macromolecules,* 2001, vol. 34, 5868-5875
- **REZA MONTAZAM et al.** Enhanced thermomechanical properties of a nematic liquid crystal elastomer doped with gold nanoparticles. *Sensors and Actuators A,* 2012, vol. 178, 175-178
- **ETSUSHI NISHIKAWA et al.** Smectic-A liquid single crystal elastomers - strain inducedbreak-down of smectic layers. *Macromolecular. Chemistry and Physics,* 1999, vol. 200, 312-322
- **YUSRIL YUSUF et al.** *Electromechanical and Electrooptical Effects of Liquid Crystal Elastomers Swollen with a Low Molecular Weight Liquid Crystal,* 2007, vol. 477 (1), 127-135
- *CHEMICAL ABSTRACTS,* 64-17-5
- *CHEMICAL ABSTRACTS,* 1310-73-2
- *CHEMICAL ABSTRACTS,* 19812-93-2
- *CHEMICAL ABSTRACTS,* 4286-55-9
- *CHEMICAL ABSTRACTS,* 7647-01-0
- *CHEMICAL ABSTRACTS,* 75-09-2
- *CHEMICAL ABSTRACTS,* 110-54-3
- *CHEMICAL ABSTRACTS,* 121-44-8
- *CHEMICAL ABSTRACTS,* 814-68-6
- *CHEMICAL ABSTRACTS,* 41424-11-7
- *CHEMICAL ABSTRACTS,* 24650-42-8
- *CHEMICAL ABSTRACTS,* 42594-17-2
- *CHEMICAL ABSTRACTS,* 13048-33-4
- *CHEMICAL ABSTRACTS,* 6729-79-9